**Europäisches Patentamt**

**European Patent Office**

**Office européen des brevets**

(19)

(11) Veröffentlichungsnummer: **0 200 021 B1**

(12) **EUROPÄISCHE PATENTSCHRIFT**

(45) Veröffentlichungstag der Patentschrift: **27.03.91**

(51) Int. Cl.5: **H01L 31/02**

(21) Anmeldenummer: **86104546.6**

(22) Anmeldetag: **03.04.86**

(54) **Lichtzündbarer Thyristor.**

(30) Priorität: **12.04.85 DE 3513229**

(43) Veröffentlichungstag der Anmeldung:
**05.11.86 Patentblatt 86/45**

(45) Bekanntmachung des Hinweises auf die
Patenterteilung:
**27.03.91 Patentblatt 91/13**

(84) Benannte Vertragsstaaten:
**CH DE FR LI SE**

(56) Entgegenhaltungen:
**GB-A- 1 579 619**
**GB-A- 2 046 472**

(73) Patentinhaber: **Schott Glaswerke**
**Hattenbergstrasse 10**
**W-6500 Mainz(DE)**

(72) Erfinder: **Schallenberg, Gerwin**
**Stichterstrasse 1**
**W-6531 Waldalgesheim(DE)**
Erfinder: **Kuhnert, Reinhold, Dr.**
**SIEMENS AG Otto-Hahn-Ring**
**W-8000 München(DE)**
Erfinder: **Mitlehner, Heinz, Dr.**
**SIEMENS AG Otto-Hahn-Ring**
**W-8000 München(DE)**

(74) Vertreter: **Dr. Fuchs, Dr. Luderschmidt**
**Dipl.-Phys. Seids, Dr. Mehler Patentanwälte**
**Abraham-Lincoln-Strasse 7**
**W-6200 Wiesbaden(DE)**

## Beschreibung

Die Erfindung bezieht sich auf einen lichtzündbaren Thyristor nach dem Oberbegriff des Patentanspruchs 1.

Ein solcher Thyristor ist aus dem IPEC-Tagungsband 1983, Seiten 559-570 bekannt. Die Zündleistung wird hierbei von einer Lichtquelle, z.B. Leuchtdiode, über einen flexiblen Lichtleiter zugeführt, dessen Ende am Gehäuse des Thyristors derart befestigt ist, daß sich sein Ausgang vor einem in den Gehäusemantel gasdicht eingefügten Fenster befindet. Im Inneren des Gehäuses wird die Zündleistung über einen vom Fenster zum lichtempfindlichen Bereich des Thyristors geführten, gebogenen Lichtleiterstab weitergeleitet, der in einer Ausnehmung des Kathodenkontaktteils gelagert ist. Nachteilig ist jedoch, daß durch die optischen Schnittstellen vor und hinter dem Fenster sowie durch nur schwer zu vermeidende Ungenauigkeiten bei der Montage des Lichtleiterstabes und des flexiblen Lichtleiters die übertragbare Lichtleistung herabgesetzt wird, was insbesondere deswegen ins Gewicht fällt, weil die zur Verfügung stehenden Lichtquellen nur eine begrenzte Lichtleistung abgeben.

Der Erfindung liegt daher die Aufgabe zugrunde, einen lichtzündbaren Thyristor der eingangs genannten Art anzugeben, der mit einer möglichst großen Zündleistung beaufschlagt werden kann, ohne hierdurch seine Austauschbarkeit insbesondere innerhalb eines Säulenaufbaus von mehreren gleichartigen Thyristoren zu beeinträchtigen. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß durch die Reduktion der Zahl der optischen Schnittstellen und durch die Selbstjustierung des flexiblen Lichtleiters im hülsenförmigen Einsatz ein wesentlich größerer Teil der zur Verfügung stehenden Lichtleistung dem lichtempfindlichen Bereich des Thyristors zugeführt werden kann als bisher. Weiterhin wird die Montage eines einzelnen Thyristors sowie die einer Mehrzahl von gleichartigen Thyristoren im Rahmen eines Säulenaufbaus erleichtert. Darüberhinaus ist eine gute Austauschbarkeit von einzelnen oder mehreren in einem Säulenaufbau zusammengefaßten Thyristoren nach der Erfindung gewährleistet.

Die Ansprüche 2 bis 9 sind auf bevorzugte Ausgestaltungen und Weiterbildungen der Erfindung gerichtet.

Die Erfindung wird nachfolgend anhand der Zeichnung näher erläutert. Dabei zeigt:

Fig. 1      ein erstes Ausführungsbeispiel der Erfindung und

Fig. 2      ein zweites Ausführungsbeispiel, das sich von Fig. 1 durch eine andere Ausgestaltung des Kühlkörpers unterscheidet.

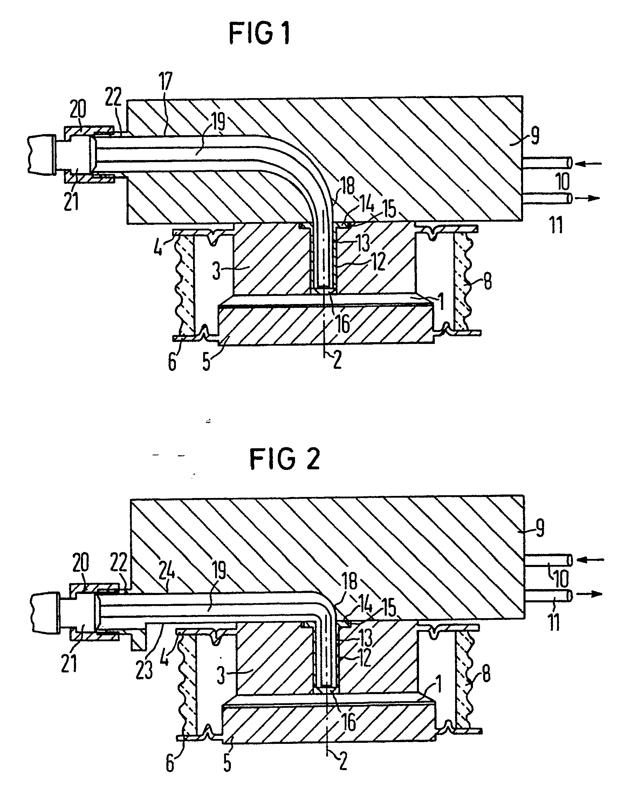

Fig. 1 zeigt einen Querschnitt durch den Gesamtaufbau eines erfindungsgemäß ausgebildeten, lichtzündbaren Hochleistungsthyristors. Dabei bezeichnet 1 eine an sich bekannte Thyristortablette, d.h. einen Körper aus dotiertem Halbleitermaterial, z.B. Silizium, der vier aufeinanderfolgende Schichten abwechselnder Leitfähigkeitstypen (n-Emitter, p-Basis, n-Basis, p-Emitter) aufweist und zur Erhöhung seiner Spannungsfestigkeit randseitig abgeschrägt ist. Er bildet eine flache, zu einer Achse 2 rotationssymmetrische Scheibe. Die Kontaktierung des n-Emitters erfolgt über ein mit einem nicht dargestellten ersten Anschluß eines Laststromkreises versehenes Kathodenkontaktteil 3, das einen flanschartigen Ansatz 4 hat. Der p-Emitter steht mit einem Anodenkontaktteil 5 in Verbindung, das mit einem flanschartigen Ansatz 6 versehen ist. Das Teil 5 weist einen zweiten, nicht dargestellten Anschluß für den Laststromkreis auf. Ein zylinderförmiger Keramikmantel 8 ist mit den Teilen 4 und 6 vorzugsweise gasdicht verschweißt. Oberhalb des Teiles 4 ist ein Kühlkörper 9 vorgesehen, der mit 3 sowie mit der Thyristortablette 1 in einem guten Wärmekontakt steht. Ein über Rohrleitungen 10 und 11 zugeführtes bzw. abgeleitetes Kühlmittel dient zur intensiven Kühlung der Thyristortablette 1.

Das Kathodenkontaktteil 3 ist im Bereich der Achse 2 mit einer zu den horizontalen Hauptflächen der Thyristortablette 1 etwa senkrecht verlaufenden, durchgehenden Bohrung 12 versehen, in die ein hülsenförmiger Einsatz 13, insbesondere aus Messing, eingefügt ist. Dieser hat einen flanschartigen Ansatz 14, der in eine Ausnehmung 15 des Teils 3 eingepaßt ist. Zweckmäßigerweise ist der Einsatz 13 an seinem unteren Ende mit einem transparenten Abschlußteil 16 versehen, das planparallel oder als plankonvexe Sammellinse ausgebildet sein kann. Dieses Abschlußteil 16 ist dabei gasdicht in den Einsatz 13 eingepaßt, der seinerseits gasdicht in die Bohrung 12 eingelötet bzw. eingeschweißt ist.

Im Kühlkörper 9 ist nun eine Ausnehmung 17 vorgesehen, die in die Bohrung 12 des Kathodenkontaktteils 3 einmündet. Beim Ausführungsbeispiel nach Fig. 1 besteht die Ausnehmung 17 aus einer etwa horizontal verlaufenden Bohrung, die einen in Richtung auf das Kathodenkontakt teil 3, d.h. in vertikaler Richtung, verlaufenden ausgangsseitigen Teil 18 aufweist. Der zur Zuführung der Zündleistung dienende Lichtleiter 19 ist flexibel ausgebildet und durch die Ausnehmung 17 mit seinem Ende bis in den hülsenförmigen Einsatz 13 einschiebbar. Mit besonderem Vorteil kann er in dieser Lage mittels einer Überwurfmutter 20, die auf dem Mantel 21 des Lichtleiters 19 drehbar gelagert ist, an einem mit einem Gewinde versehenen Eingangsstutzen 22 des Kühlkörpers 9 befestigt werden. Der Querschnitt der Ausnehmung 17 verringert sich im Bereich des ausgangsseitigen Teils 18 in Richtung auf ihren in die Bohrung 12 einmündenden Ausgang derart, daß er an diesem Ausgang dem Querschnitt des hülsenförmigen Einsatzes 13 entspricht.

Fig. 2 zeigt eine andere Ausführungsform der Erfindung, die sich von Fig. 1 dadurch unterscheidet, daß die Ausnehmung des Kühlkörpers 9 aus einer von seiner Grenzfläche 23 zum Kathodenkontaktteil 3 ausgehenden Nut 24 besteht, die z.B. eingefräst ist. Auch die Nut 24 mundet in die Bohrung 12 bzw. in den oberen Querschnitt des hülsenförmigen Einsatzes 13.

Die Teile 3 bis 8, 13 und 16 bilden ein gasdichtes Gehäuse für die Thyristortablette 1, wobei der flexible, aus einer einzigen Lichtleitfaser oder einem Faserbündel bestehende Lichtleiter 19, der bis an das Abschlußteil 16 vordringt, ohne Zwischenschaltung eines weiteren starren Lichtleiterstabes mit dem lichtempfindlichen Bereich der Thyristortablette in optischem Kontakt steht. Bei einem säulenartigen Aufbau mehrer nach der Erfindung ausgebildeter Thyristoren kann jeweils die zu einem solchen Thyristor gehörende, aus den Teilen 1 bis 8 bestehende Baueinheit nach dem Entfernen des Lichtleiters 19 als Ganzes ausgetauscht werden. Der Licht leiter 19 wird nach dem Einbringen der neuen Baueinheit an den Eingangsstutzen 22 wieder angeschraubt.

## Ansprüche

1. Lichtzündbarer Thyristor mit einem Kathodenkontaktteil (3), einem an dieses angrenzenden Kühlkörper (9) und einem zur Zuführung der Zündleistung dienenden, in einer Bohrung (12) des Kathodenkontaktteils (3) angeordneten Lichtleiter (19), der mit einem lichtempfindlichen Bereich des Thyristors in optischem Kontakt steht, **dadurch gekennzeichnet** daß ein hülsenförmiger Einsatz (13) in die Bohrung (12) eingefügt ist und daß der Lichtleiter (19) flexibel ausgebildet und durch eine Ausnehmung (17, 18) des Kühlkörpers (9), die in diese Bohrung (12) einmündet, in den hülsenförmigen Einsatz (13) einschiebbar ist.

2. Lichtzündbarer Thyristor nach Anspruch 1, **dadurch gekennzeichnet,** daß der hülsenförmige Einsatz (13) mit einem transparenten, insbesondere planparallel oder als Sammellinse ausgebildeten Abschlußteil (16) versehen ist.

3. Lichtzündbarer Thyristor nach Anspruch 1 oder 2, **dadurch gekennzeichnet** daß die Ausnehmung des Kühlkörpers (9) aus einer Bohrung (17) besteht die in einem ersten Teil etwa parallel zu den Hauptflächen des scheibenförmig ausgebildeten Thyristors(1)verläuft und einen in Richtung auf das Kathodenkontaktteil verlaufenden ausgangsseitigen zweiten Teil (18) aufweist.

4. Lichtzündbarer Thyristor nach Anspruch 1 oder 2, **dadurch gekennzeichnet,** daß die Ausnehmung des Kühlkörpers (9) aus einer von seiner Grenzfläche (23) zum Kathodenkontaktteil (3) ausgehenden Nut (24) besteht, die in die Bohrung (12) des Kathodenkontaktteils (3) einmündet.

5. Lichtzündbarer Thyristor nach einem der vorhergehenden Ansprüche, **dadurch gekennzeichnet,** daß er im wesentlichen rotationssymmetrisch ausgebildet ist und daß sich die Bohrung (12) des Kathodenkontaktteils (3) im Bereich der Symmetrieachse (2) befindet.

6. Lichtzündbarer Thyristor nach einem der vorhergehenden Ansprüche, **dadurch gekennzeichnet,** daß der hülsenförmige Einsatz (13) in die Bohrung (12) des Kathodenkontaktteils (3) gasdicht eingelötet bzw. eingeschweißt ist.

7. Lichtzündbarer Thyristor nach einem der vorhergehenden Ansprüche, **dadurch gekennzeichnet,** daß der Lichtleiter (19) mittels einer auf ihm drehbar gelagerten Überwurfmutter (20) an einem Eingangsstutzen (22) des Kühlkörpers (9) befestigbar ist.

8. Lichtzündbarer Thyristor nach einem der vorhergehenden Ansprüche, **dadurch gekennzeichnet,** daß sich der Querschnitt der Ausnehmung (17) des Kühlkörpers (9) in Richtung auf ihren in die Bohrung (12) des Kathodenkontaktteils (3) einmündenden Ausgang derart verjüngt, daß er an diesem Ausgang dem Querschnitt des hülsenförmigen Einsatzes (13) entspricht.

9. Lichtzündbarer Thyristor nach einem der vorhergehenden Ansprüche, **dadurch gekennzeichnet,** daß das Kathodenkontaktteil (3, 4) mit einem Anodenkontaktteil (5,6) und einem Keramikmantel (8) zu einem gasdichten Gehäuse zusammengefügt ist.

## Claims

1. A light-ignitable thyristor having a cathodic contact piece (3), a heat dissipator (9) adjacent to said cathodic contact piece (3), and a light guide (19) serving as a lead for the ignition power and being arranged in a boring (12) of said cathodic contact piece, said light guide (19) optically contacting a light-sensitive portion of said thyristor, characterized in that a bush-shaped insert (13) is mounted in the boring (12) and that the light guide (19) is flexibly developed and can be introduced in that bush-shaped insert (13) via a recess (17, 18) of said heat dissipator which leads to said boring (12).

2. A light-ignitable thyristor according to claim 1, characterized in that the bush-shaped insert (13) is provided with a transparent terminal piece (16) preferably being shaped plan-parallel or as a focusing lense.

3. A light-ignitable thyristor according to claims 1 or 2, characterized in that the recess of the heat dissipator (9) consists of a boring (17) running in a first portion approximately parallel to the main surfaces of the disc-shaped thyristor and that said recess comprises at its output side a second portion (18) running in the direction of a cathodic contact piece.

4. A light-ignitable thyristor according to claims 1 or 2, characterized in that the recess of the heat dissipator (9) consists of a groove (24) starting from the interface (23) to the cathodic contact piece (3), said groove leading to the boring (12) of the cathodic contact piece (3).

5. A light-ignitable thyristor according to anyone of the preceding claims, characterized in that it is essentially shaped dynamically balanced and that the boring (12) of the cathodic contact piece (3) is located in the area of the axis of symmetry (2).

6. A light-ignitable thyristor according to anyone of the preceding claims, characterized in that the bush-shaped insert (13) is soldered or welded respectively into the boring (12) of the cathodic contact piece (3) in a gastight manner.

7. A light-ignitable thyristor according to anyone of the proceding claims, characterized in that the light guide (19) can be mounted at an input connecting piece (22) of the heat dissipator (9) by means of a pivoted swivel nut (20).

8. A light-ignitable thyristor according to anyone of the preceding claims, characterized in that the cross-section of said recess (17) of the heat dissipator (9) is tapered in the direction of its output which leads in the boring (12) of the cathodic contact piece (3) thus that, at said output, it corresponds to the cross-section of the bush-shaped insert (13).

9. A light-ignitable thyristor according to anyone of the preceding claims, characterized in that that the cathodic contact piece (3, 4) is connected with an anodic contact piece (5, 6) and a ceramic envelope (8) to a gastight can.

## Revendications

1. Thyristor pouvant être déclenché par la lumière comportant un élément de contact de cathode (3), un radiateur (9) contiguë à celui-ci, et une fibre optique (19) permettant d'amener l'énergie de déclenchement, montée dans un alésage (12) de l'élément de contact de cathode (3), qui est en contact optique avec une zone photo-senbible du thyristor, caractérisé en ce que, un insert (13) en forme de douille est monté dans l'alésage (12) et en ce que la fibre optique (19) est flexible et peut être engagée dans l'insert (13) en forme de douille par une cavité (17, 18) du radiateur (9), qui débouche dans le perçage (12).

2. Thysristor pouvant être déclenché par la lumière selon la revendication 1, caractérisé en ce que l'insert (13) en forme de douille est muni d'un élément d'obturation (16) transparent, notamment plan à surfaces parallèles ou en forme de lentille convexe.

3. Thysristor pouvant être déclenché par la lumière selon la revendication 1 ou 2, caractérisé en ce que la cavité du radiateur (9) se compose d'un perçage (17) qui, dans une première partie, s'étend sensiblement parallèlement aux surfaces principales du thyristor en forme de disque, et dans une deuxième partie (18) côté sortie, s'étend en direction de l'élément de contact de cathode.

4. Thysristor pouvant être déclenché par la lumière selon la revendication 1 ou 2, caractérisé en ce que la cavité du radiateur (9) se compose d'une rainure (24) qui s'étend à partir de son interface avec l'élément de contact de cathode (3) et qui débouche dans le perçage (12) de l'élément de contact de cathode (3).

5. Thysristor pouvant être déclenché par la lumière selon l'une des revendications précédentes, caractérisé en ce qu'il est essentiellement symétrique de rotation et en ce que le perçage (12) de l'élément de contact de cathode (3) est situé dans la zone de l'axe de symétrie (2).

6. Thyristor pouvant être déclenché par la lumière selon l'une des revendications précédentes, caractérisé en ce que l'insert (13) en forme de douille est soudé ou brasé de manière étanche au gaz dans le perçage (12) de l'élément de contact de cathode (3).

7. Thyristor pouvant être déclenché par la lumière selon l'une des revendications précédentes, caractérisé en ce que la fibre optique (19) peut être fixée sur un bossage d'entrée (22) du radiateur (9) au moyen d'un écrou (20) monté mobile en rotation sur la fibre optique.

8. Thyristor pouvant être déclenché par la lumière selon l'une des revendications précédentes, caractérisé en ce que la section de la cavité (17) du radiateur (9) décroit en direction de son extrémité débouchant dans le perçage (12) de l'élément de contact de cathode (3) de manière telle qu'elle corresponde au niveau de cette extrémité à la section de l'insert (13) en forme de douille.

9. Thyristor pouvant être déclenché par la lumière selon l'une des revendications précédentes, caractérisé en ce que l'élément de contact de cathode (3, 4), un élément de contact d'anode (5, 6) et une enveloppe céramique (8) sont assemblés pour former un boîtier étanche au gaz.

# FIG 1

# FIG 2